# FASCICULE DE BREVET EUROPEEN

(11) **EP 1 820 228 B1**
(45) Date de publication et mention de la délivrance du brevet: **28.09.2011**
(21) Numéro de dépôt: 05823530.0
(22) Date de dépôt: 24.11.2005
(51) Int. Cl.: H01L 51/50

(54) **DIODE ORGANIQUE ELECTROLUMINESCENTE A COUCHES DOPEES**
ORGANISCHE LEUCHTDIODE MIT DOTIERTEN SCHICHTEN
ORGANIC LIGHT-EMITTING DIODE HAVING DOPED LAYERS

(30) Priorité: 29.11.2004 FR 0452802
(43) Date de publication de la demande: 22.08.2007
(73) Titulaire: Thomson Licensing SAS, 92130 Issy-les-Moulineaux (FR)
(72) Inventeur: FERY, Christophe, F-35000 Rennes (FR); CINA, Salvatore, F-38000 Grenoble (FR); RACINE, Benoit, F-38500 Voiron (FR)
(74) Mandataire: Browaeys, Jean-Philippe
(86) Numéro de dépôt international: PCT/EP2005/056196
(87) Numéro de publication internationale: WO 2006/056586

(56) Documents cités:
- EP-A- 0 498 979
- EP-A- 1 347 518
- US-A- 5 674 597
- US-A1- 2002 055 015
- US-A1- 2003 111 666
- US-A1- 2003 143 428
- US-A1- 2004 265 630
- PATENT ABSTRACTS OF JAPAN vol. 2003, no. 04, 2 avril 2003 (2003-04-02) -& JP 2002 352961 A (TORAY IND INC), 6 décembre 2002 (2002-12-06)

## Description

L'invention concerne une diode organique électroluminescente comprenant :
- un substrat,
- une électrode inférieure d'un premier genre du côté du substrat et une électrode supérieure d'un second genre à l'opposé du substrat, les genres d'électrodes correspondant à anode et cathode,
- une couche organique électroluminescente émissive qui est intercalée entre l'électrode inférieure et l'électrode supérieure,
- et au moins une couche organique dopée en contact avec l'une desdites électrodes, qui est intercalée entre cette électrode et ladite couche électroluminescente, et qui est dopée avec un dopant donneur si ladite électrode en contact est une cathode, ou avec un dopant accepteur si ladite électrode en contact est une anode.

L'invention concerne également les panneaux d'éclairage ou d'affichage d'images comprenant un réseau de ces diodes partageant le même substrat.

Comme l'enseigne le document EP0498979 - TOSHIBA - voir page 2 - une telle couche organique dopée permet d'injecter et de transporter les charges électriques entre l'électrode au contact de laquelle elle se trouve et la couche électroluminescente avec une résistance électrique bien moindre qu'en utilisant une couche organique d'injection et une couche organique de transport non dopées. La tension d'alimentation des diodes de ce type est alors sensiblement abaissée et leur rendement lumineux amélioré.
Le document US 2002/0055015 décrit une diode organique éléctroluminescente dans laquelle la couche transporteuse d'éléctrons est dopée avec un métal alkalin. Le dopage peut être réalisé de telle manière qu'il y ait une distribution de concentration du métal alkalin dans la direction verticale. Le document JP 2002/352961 décrit une diode organique électroluminescente dans laquelle une couche transporteuse d'électrons est dopée avec un dopant de type donneur et une couche non dopée de faible épaisseur est formée entre la couche dopée et la couche électroluminescente.

L'avantage de l'utilisation de couches organiques dopées pour injecter et transporter des charges, électrons ou trous, dans la couche émissive électroluminescente, au lieu de couches d'injection et de transport de charges de l'art antérieur, est double ; on obtient en effet à la fois :
- une réduction de la barrière d'injection de charges,
- et une diminution des pertes ohmiques dans les couches d'injection et de transport de charges, puisque ces couches présentent une conductivité élevée du fait du dopage.

Ces deux avantages connus reposent donc sur le dopage des couches organiques qui servent à l'injection et au transport des charges ; cependant, il est difficile de trouver un niveau de dopage d'un matériau qui permette d'optimiser à la fois les propriétés d'injection et les propriétés de transport recherchées.

Un but de l'invention est d'apporter un moyen permettant d'optimiser ces deux avantages.

A cet effet, l'invention a pour objet une diode organique électroluminescente telle que décrit dans la revendication 1.

Plus précisément, la couche en contact avec l'une desdites électrodes est en matériau organique dopé avec un dopant donneur si ladite électrode en contact est une cathode, et/ou avec un dopant accepteur si ladite électrode en contact est une anode ; on entend par dopant donneur ou « n » un dopant apte à augmenter la densité de niveaux d'énergie pour les électrons au voisinage du niveau du LUMO de ce matériau ; on entend par dopant accepteur ou « p » un dopant apte à augmenter la densité de niveaux d'énergie pour les trous au voisinage du niveau du HOMO de ce matériau ; grâce à ce dopage, il y a donc transfert de charges entre le matériau organique « hôte » et le dopant : transfert d'électrons du dopant vers le matériau hôte dans le cas d'un dopage n de ce matériau « hôte », transfert d'électrons du matériau hôte vers le dopant dans le cas d'un dopage p de ce matériau « hôte ». Pour que ce transfert de charges puisse s'effectuer, il convient de limiter la barrière de potentiel pour ce transfert ; ainsi, il est préférable que, si l'électrode en contact avec la couche dopée est une cathode, la différence, en valeur absolue, entre d'une part l'énergie du niveau du HOMO ou le potentiel d'ionisation du dopant donneur et d'autre part l'énergie du niveau du LUMO du matériau organique de la couche dopée soit inférieure à 5 eV, et/ou que, si l'électrode en contact avec la couche dopée est une anode, la différence, en valeur absolue, entre d'une part l'énergie du niveau du LUMO ou l'affinité électronique du dopant accepteur et d'autre part l'énergie du niveau du HOMO du matériau organique de la couche dopée soit inférieure à 5 eV. Par convention, les énergies des niveaux HOMO ou LUMO sont ici comptées positivement par rapport au niveau d'énergie d'un électron dans le vide. Afin d'assurer un meilleur transfert de charges cette fois entre la couche dopée et l'électrode avec laquelle elle est en contact, il est en outre souhaitable que, si l'électrode en contact avec la couche dopée est une cathode, l'énergie du niveau du HOMO ou le potentiel d'ionisation du dopant donneur soit supérieure à l'énergie du niveau du LUMO du matériau organique de la couche dopée, et/ou que, si l'électrode en contact avec la couche dopée est une anode, l'énergie du niveau du LUMO ou l'affinité électronique du dopant accepteur soit inférieure ou égale à l'énergie du niveau du HOMO du matériau organique de la couche dopée.

La définition des dopants qui est conforme à l'invention ne recouvre donc pas celle qui est donnée dans le document EP1347518, où le dopage consiste en une « dispersion » d'un composé inorganique semi-conducteur dans une matrice organique, ce caractère de dispersion ayant alors pour but d'augmenter la surface de contact entre le matériau organique et le composé inorganique (voir page 6, ligne 12 de ce document).

La définition des dopants qui est conforme à l'invention ne saurait davantage aboutir au matériau de la couche tampon qui est décrite dans le document US2003/143428 ; selon ce document, ce matériau est formé par le mélange d'un composé organique et d'un composé alcalin ou alcalino-terreux (voir §23) ; ce mélange présente un gradient de concentration de ses deux composants ; la couche tampon qui est décrite est directement au contact d'une électrode, ici une cathode, et seul le dopage de type n (dopant donneur) est donc considéré ; la couche tampon peut être directement au contact de la couche électroluminescente émissive (voir §42) ; il ne s'agit en aucun cas ici d'une couche dopée n au sens de l'invention : en effet, même si les composés alcalins ou alcalino-terreux du mélange de cette couche sont couramment utilisés comme dopants n (donneurs), l'autre composant (le composé organique) du mélange n'est pas apte à être dopé n au sens de l'invention, notamment s'il s'agit de composés organiques de type « starburst » tels que cités dans ce document.

De manière générale, l'invention repose notamment sur le principe suivant lequel le niveau de dopage en dopant de l'au moins une couche organique dopée est plus élevé à l'interface entre cette couche organique et l'électrode avec laquelle cette couche est en contact qu'au coeur de cette couche organique dopée.

Grâce à un niveau de dopage différent à l'interface avec l'électrode et au coeur de la couche organique dopée, on peut à la fois diminuer l'épaisseur de la barrière de potentiel à l'interface et augmenter la résistance électrique au coeur du matériau puisque le niveau de dopage est plus faible, ce qui permet d'optimiser à la fois les propriétés d'injection et les propriétés de transport de charges (électrons ou trous) de cette couche dopée. Il existe une barrière de potentiel supérieure à 0,2 eV audit interface.

A température ambiante, cette interface forme donc une jonction Schottky.

Si ladite électrode à cette interface est une cathode, si le matériau de l'électrode à cette interface est un métal qui présente un travail de sortie EM1, si le matériau O1 de ladite couche organique dopée n en donneurs à cette interface présente un niveau de Fermi E1 et un niveau de LUMO (« Lowest Unoccupied Molecular Orbital » en langue anglaise) EC 1, alors on a |EMC1 - EM1| > 0.2 eV et EM1 > E1 (la condition inverse EM1 < E1 impliquerait au contraire un contact ohmique). Le mécanisme d'injection d'électrons à cette interface est alors le suivant : les électrons qui peuplent les niveaux « donneurs » à proximité de cette interface passent dans le métal M1, qui est un réservoir infini de charges et le dépeuplement des niveaux « donneurs » dans le matériau organique semi-conducteur O1 à proximité de cette interface donne lieu à une charge locale positive qui forme une barrière de potentiel à l'interface et le niveau EC1 du LUMO présente alors une courbure à proximité de cette interface. L'épaisseur de cette barrière qui correspond à l'étendue de cette courbure est de l'ordre que quelques nanomètres. Quand on applique une différence de potentiel à la diode dans le sens passant pour émettre de la lumière, les électrons traversent cette barrière par effet tunnel.

Plus généralement, on peut également définir pour le matériau organique dopé O1 l'énergie E1 du niveau de Fermi, et celle EV1 du niveau du HOMO (« Highest Occupied Molecular Orbital » en langue anglaise) ; le dopage n en niveaux donneurs de ce matériau se traduit par la relation : E1 - EC1 < EV1 - E1,

Si ladite électrode à cette interface est une anode, si le matériau de l'électrode à cette interface est un métal qui présente un travail de sortie EM2, si le matériau 02 de ladite couche organique dopée p en accepteurs à cette interface présente un niveau de Fermi E2 et un niveau du HOMO EV2, alors on a |EV2 - EM2| > 0.2 eV et EM2 < E2 (la condition inverse EM2 > E2 impliquerait au contraire un contact ohmique). Le mécanisme d'injection des trous à cette interface est alors le suivant : les trous qui peuplent les niveaux « accepteurs » à proximité de cette interface passent dans le métal M2, qui est un réservoir infini de charges et le dépeuplement des niveaux « accepteurs » dans le matériau organique semi-conducteur 02 à proximité de cette interface donne lieu à une charge locale négative qui forme une barrière de potentiel à l'interface et le niveau EV2 du HOMO présente alors une courbure à proximité de cette interface. L'épaisseur de cette barrière qui correspond à l'étendue de cette courbure est de l'ordre que quelques nanomètres. Quand on applique une différence de potentiel à la diode dans le sens passant pour émettre de la lumière, les trous traversent cette barrière par effet tunnel.

Plus généralement, on peut également définir pour le matériau organique dopé 02 l'énergie E2 du niveau de Fermi, et celle EC2 du niveau du LUMO ; le dopage p en niveaux accepteurs de ce matériau se traduit par la relation : E2 - EC2 > EV2 - E2.

De préférence, la conductivité moyenne du matériau de ladite couche organique dopée est au moins trois fois plus élevée dans une tranche de cette couche de 10 nm d'épaisseur, située à l'interface et au contact avec ladite électrode, que dans une tranche d'au moins 10 nm d'épaisseur située au coeur de cette couche organique dopée à plus de 20 nm de ladite électrode.

La mesure de conductivité de cette couche organique dopée peut être effectuée par une méthode analogue à celle qui est décrite ultérieurement pour l'obtention de cette couche organique dopée, et notamment par mesure de la variation de la résistance de cette couche entre deux électrodes de mesure au fur et à mesure du décapage de cette couche : la variation de résistance pour 10 nm décapé au coeur, c'est à dire à plus de 20 nm de l'électrode de la diode, sera alors au moins trois moins élevée que la variation de résistance pour 10 nm décapé à proximité et au contact de l'électrode de la diode.

De préférence, la concentration moyenne en dopant dans le matériau de ladite couche organique dopée est au moins trois fois plus élevée dans une tranche de cette couche située à l'interface et au contact avec ladite électrode que dans une tranche située au coeur de cette couche organique dopée à plus de 10 nm de ladite électrode.

L'épaisseur des tranches dépend de la méthode d'analyse utilisée ; elle est de préférence de l'ordre de 10 nm. Comme méthode d'analyse, on peut utiliser par exemple :
- la spectroscopie de masse des ions secondaires (« SIMS », ou « Second Ion Mass Spectroscopy » en langue anglaise) ;
- la rétro-diffusion Rutherford (« RBS » ou « Rutherford Back Scattering » en langue anglaise) ;
- l'Analyse de Réaction Nucléaire (« NRA », ou « Nuclear Reaction Analysis » en langue anglaise).

Pour établir le gradient de concentration en dopant selon l'invention à l'aide de ces méthodes, il peut être nécessaire de préparer des échantillons d'étalonnage et de calibrage, selon une méthode connue en elle-même.

De préférence, la diode comprend une couche organique de blocage intercalée entre l'au moins une couche organique dopée et ladite couche électroluminescente, blocage de trous si la dite couche organique dopée est au contact d'une cathode, blocage d'électrons si la dite couche organique dopée est au contact d'une anode. Selon une variante, le matériau de base de cette couche de blocage est identique à celui de la couche organique dopée, auquel cas ce matériau n'est pas dopé de manière significative dans l'épaisseur de la couche dite de blocage.

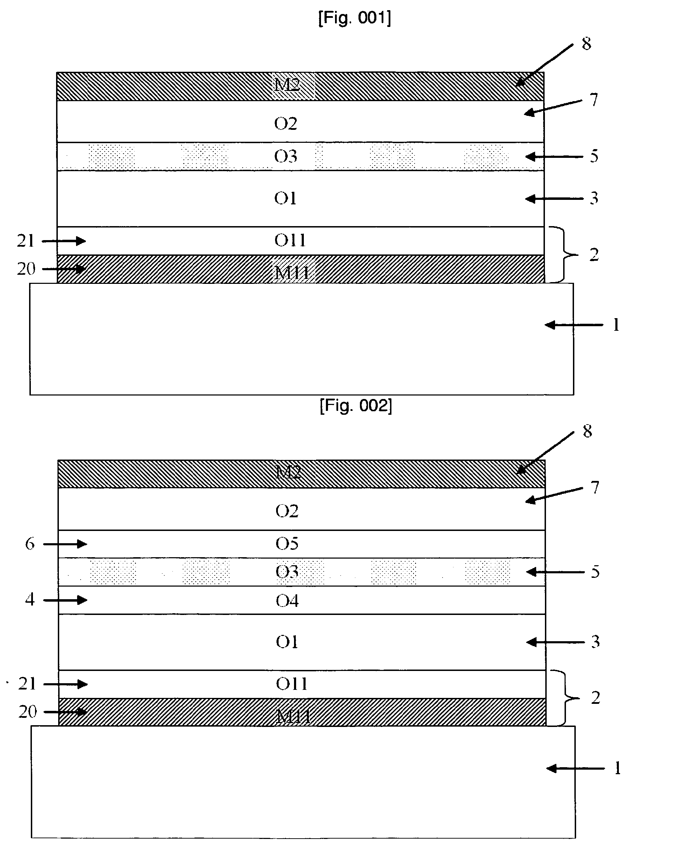

Ainsi, si le matériau de la couche organique dopée de la diode selon l'invention présente un gradient de concentration en dopant dans la tranche de cette couche qui est située entre son interface avec l'électrode au contact de laquelle elle est et le coeur de cette couche, à l'inverse, dans la tranche opposée de cette couche, qui est située entre son coeur et la limite de cette couche qui est opposée à cette électrode, la concentration en ce même dopant peut être beaucoup plus faible voir nulle, afin, par exemple, de ménager une tranche de cette couche pour le blocage de charges. Mais, afin de préserver l'avantage précédemment cité de faibles pertes ohmiques apporté par les couches dopées d'injection et de transport de charges dans les diodes selon l'invention, il est préférable que, si, dans le matériau de cette couche organique, la concentration en dopant est nulle ou quasi nulle à la limite de cette couche qui est opposée à ladite électrode avec laquelle elle est contact, l'épaisseur de la tranche de concentration nulle ou quasi nulle dans cette couche reste strictement inférieure à l'épaisseur de la tranche de concentration non nulle en dopant. La tranche de concentration non nulle inclut alors la zone de gradient de concentration en dopant. La couche de concentration nulle en dopant présente évidemment un conductivité plus faible ; en limitant son épaisseur, on limite aussi les pertes ohmiques. On remarquera à l'inverse que, dans le document US2003-111666, l'une au moins des couches d'injection et de transport de charges des diodes décrites comprend une tranche dopée au contact d'une électrode et une tranche non dopée, généralement elle-même au contact d'une couche de blocage (figures 2B, 4B, 5, 6B, 7, 9A et 9B) sinon directement au contact de la couche électroluminescente (tranches référencées 915 et 932 sur les figures 9A et 9B). En tout état de cause, dans ce document, l'épaisseur de la tranche non dopée (généralement 40 nm) est strictement supérieure à l'épaisseur de la tranche dopée (au maximum 30 nm pour les tranches 916 et 931 sur les figures 9A et 9B, sinon 5 nm), ce qui ne permet pas, à l'inverse de l'invention, de maintenir de faible pertes ohmiques.

Des couches de blocage sont décrites dans le document EP1017118 - SHARP sous le nom de « restraining layers » en langue anglaise. De telles couches de blocage servent à limiter les recombinaisons électrons-trous en dehors de la couche électroluminescente, de manière à maintenir un rendement lumineux élevé. De telles couches de blocage sont particulièrement utiles lorsque la couche électroluminescente comprend des dopants phosphorescents qui permettent la recombinaison radiative des excitons électrons-trous dits « triplets » , car ces excitons ont une durée de vie qui leur permet de diffuser sur plusieurs centaines de nanomètres, ce qui rend le blocage des électrons ou trous d'autant plus utile pour éviter les recombinaisons non radiatives. On se référera par exemple à l'article intitulé « High-Efficiency Organic Light-Emitting Diodes », des auteurs N.K. Patel, S. Cina et J.H. Burroughes, dans « IEEE journal on selected topics in quantum electronics », Vol.8, N°2, Mars-Avril 2002, pp.346-361, qui décrit l'importance des triplets et des dopants phosphorescents pour améliorer l'efficacité lumineuse des diodes organiques électroluminescentes.

L'invention a également pour objet un panneau d'éclairage ou d'affichage d'images comprenant un réseau de diodes selon l'invention, où les diodes de ce réseau sont supportées par le même substrat.

De préférence, ledit substrat est une matrice active comprenant un réseau de circuits de commande et d'alimentation.

De préférence, les électrodes inférieures de ces diodes sont des cathodes ; chaque circuit de commande et d'alimentation correspond à une diode du panneau et comprend alors un transistor de type n de modulation de courant qui est relié en série avec cette diode.

La combinaison de cette structure dite « inversée » et d'un transistor de modulation de type n permet d'assurer à chaque transistor de commander une diode indépendamment de la chute de tension aux bornes de cette diode.

De préférence, le substrat comprend une couche de matériau semi-conducteur en silicium amorphe. Chaque transistor de modulation comprend alors une portion de cette couche de silicium.

L'invention sera mieux comprise à la lecture de la description qui va suivre, donnée à titre d'exemple non limitatif, et en référence aux figures annexées sur lesquelles :
- la figure 1 illustre un premier mode de réalisation d'une diode selon l'invention, qui ne comprend pas de couches de blocage ;
- la figure 2 illustre un deuxième mode de réalisation d'une diode selon l'invention, qui comprend des couches de blocage ;
- la figure 3 illustre la variation en concentration de dopant dans la couche organique dopée au contact de l'électrode inférieure de la diode de la figure 1 ou 2, en fonction de la distance à l'interface avec cette électrode ;
- la figure 4 montre les caractéristiques courant-tension d'une diode selon un exemple de réalisation de l'invention (symboles ronds blancs) conforme au deuxième mode de réalisation en comparaison de celles d'une diode selon l'art antérieur (symboles carrés noirs).
- la figure 5 illustre schématiquement un montage électrique permettant d'évaluer la conductivité superficielle par rapport à la conductivité à coeur d'une couche organique.

On va maintenant décrire la fabrication d'une diode selon un premier mode de réalisation de l'invention en se référant à la figure 1.

Sur un substrat de verre 1, on dépose une couche 20 de matériau conducteur M11 ; ce matériau conducteur M11 est par exemple de l'ITO (« Indium Tin Oxide » en langue anglaise) déposé par pulvérisation cathodique sous vide.

Sur cette couche 20, on dépose une couche conductrice de planéité 21 en matériau organique O11, ici du PEDOT-PSS. Le PEDOT-PSS est un mélange de PEDOT (poly-3,4-éthylène dioxythiophène) et de PSS (poly-styrène sulfonate) qui n'est pas réputé très adapté au transport des électrons puisque le travail de sortie de ce matériau est relativement élevé (> 5 eV). Cependant, grâce au niveau élevé de dopage n à l'interface avec la couche organique inférieure dopée 3 décrite ultérieurement, il est possible d'y injecter des électrons.

L'empilement des couches 20 et 21 forme ici l'électrode inférieure 2 servant ici de cathode.

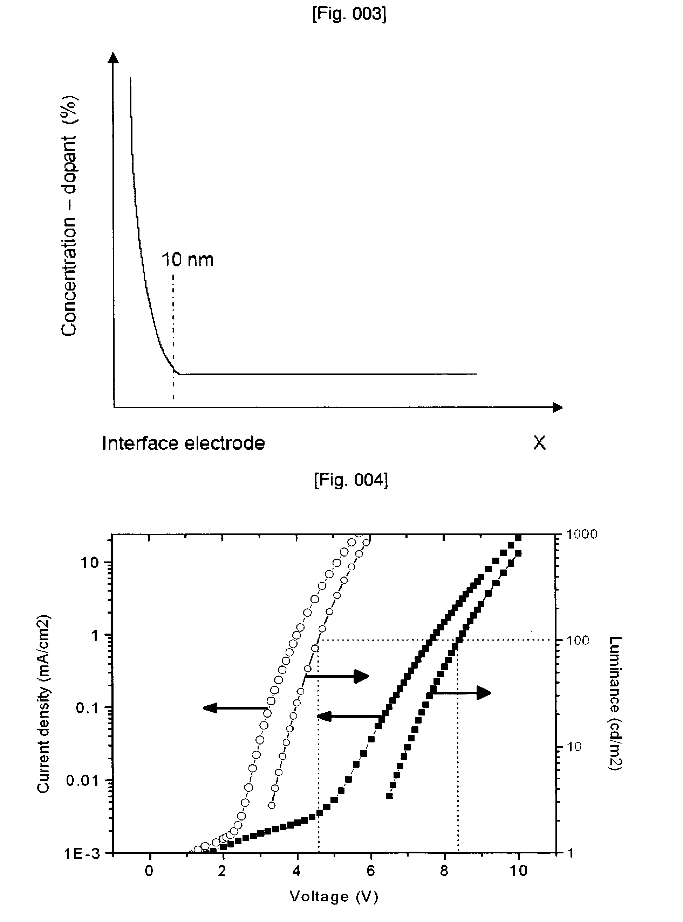

Sur cette électrode 2 bi-couche, on dépose une couche organique inférieure 3 en matériau O1 dopé n. Selon l'invention, la concentration en dopant donneurs est beaucoup plus élevée à l'interface (x=0) avec l'électrode 2 qu'au coeur de ce matériau O1 (x>0), comme l'illustre la courbe de la figure 3.

De préférence, ce profil de dopage est adapté pour que la conductivité du matériau de la couche organique inférieure 3 soit au moins trois fois plus élevée à l'interface avec cette électrode 2 qu'au coeur de cette couche organique inférieure 3.

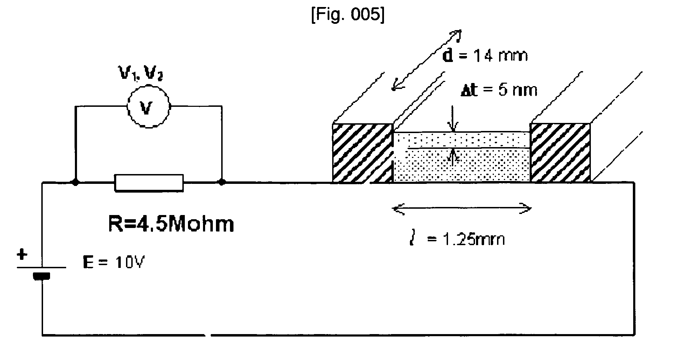

Afin d'assurer ce profil de conductivité avantageux, on utilise par exemple le montage de la figure 5, où, dans l'enceinte de dépôt, le matériau O1 est déposé entre deux électrodes métalliques (section hachurée sur la figure) qui sont distantes de 1 = 1,25 mm, s'étendent sur d = 14 mm, et qui sont reliées à un dispositif de mesure de résistance. Ce dispositif comprend ici un générateur de tension continue E = 10 V et une résistance étalon R = 4,5 MΩ reliés en série_ ; la mesure de la tension aux bornes de la résistance étalon donne la valeur de résistance entre les deux électrodes. Tout dispositif analogue peut être utilisé sans se départir de l'invention.

Afin d'assurer ce profil de conductivité avantageux, on adapte la proportion de dopant au moment du dépôt de O1 de manière à_ :
- obtenir une variation de tension aux bornes de la résistance-étalon de 30 mV pour 10 nm d'épaisseur, pour les dix à vingt premiers nanomètres de la couche 3 déposés sur l'électrode 2;
- obtenir une variation de tension aux bornes de la résistance-étalon de seulement 12 mV pour 10 nm d'épaisseur, pour les dizaines de nanomètres déposées ultérieurement, et qui correspondent notamment au coeur de la couche 3.

Sur cette couche organique inférieure dopée 3 déposée avec cette méthode de calibrage du dopage, on dépose ensuite une couche organique électroluminescente 5 en matériau O3_ ; ce matériau 03 n'est généralement pas dopé en éléments donneurs ou accepteurs_ ; ce matériau 03 est de préférence dopé par un dopant fluorescent ou phosphorescent comme illustré par exemple dans l'article « High-Efficiency Organic Light-Emitting Diodes » - IEEE journal - déjà cité.

Sur cette organique électroluminescente 5, on dépose une couche organique supérieure 7 en matériau 02 dopé p. Ici, la concentration en dopant accepteurs est approximativement constante dans toute l'épaisseur de cette couche. Selon une variante, la concentration en dopant accepteurs est beaucoup plus élevée à l'interface avec l'électrode 8 qui va la revêtir qu'au coeur de ce matériau 02.

Sur cette couche organique supérieure dopée 7, on dépose une couche de métal M2, pour servir d'électrode supérieure 8, ici une anode.

On obtient ainsi une diode selon l'invention.

Grâce à l'invention, l'augmentation du dopage des couches organiques dopées à l'interface avec l'électrode avec laquelle elle est en contact permet de diminuer sensiblement la tension d'alimentation requise pour obtenir un courant prédéterminé, et donc un éclairement prédéterminé, comme l'illustre l'exemple ci-après. L'invention permet d'améliorer considérablement le rendement lumineux des diodes organiques électroluminescentes.

En référence à la figure 2, la fabrication d'une diode selon un deuxième mode de réalisation de l'invention découle de la description du premier mode de réalisation. Dans ce deuxième mode de réalisation, on interpose :
- une couche de blocage de trous 4 en matériau organique 04 entre la couche dopée 3 et la couche électroluminescente 5,
- et une couche de blocage d'électrons 6 en matériau organique O5 entre la couche électroluminescente 5 et la couche dopée 7.

On obtient ainsi une autre diode selon l'invention.

L'invention s'applique également aux panneaux d'éclairage ou d'affichage d'images comprenant un réseau de telles diodes.

La présente invention a été décrite en se référant à une diode comprenant à la fois une couche organique dopée inférieure et une couche organique dopée supérieure, où l'électrode inférieure est une cathode et l'électrode supérieure est une anode ; il est évident pour l'homme du l'art qu'elle peut s'appliquer à d'autres types de diodes sans sortir du cadre des revendications ci-après.

L'exemple suivant illustre l'invention.

La diode présentée dans cet exemple présente la même structure que celle du deuxième mode de réalisation de l'invention qui vient d'être décrit.

Du bas vers le haut en partant du substrat 1, cette diode présente les couches suivantes :
- couche métallique 20 en ITO d'épaisseur 150 nm environ ;
- couche 21 en PEDOT-PSS, de la Société BAYER, dénommé commercialement Baytron VPAI 4083 ou Baytron VPCH 8000, d'épaisseur 40 nm ; cette couche est avantageusement réalisée par dépôt centrifuge (« spin coating » en langue anglaise) ; cette couche assure une bonne planéité très avantageuse pour assurer de bonnes performances à la diode et pour limiter l'épaisseur et donc les coûts des couches supérieures ; elle contribue également au fonctionnement de la cathode, puisque ici le matériau PEDOT-PSS est utilisé ici pour transporter des électrons ; l'épaisseur de cette couche peut être si besoin sensiblement plus épaisse ;
- couche inférieure 3 en 4,7-diphényl-1,10-phénanthroline (« Bphen »), dopée n avec du césium, d'épaisseur 100 nm ; le niveau de dopage en césium est adapté comme décrit précédemment pour obtenir à l'interface avec l'électrode inférieure une conductivité trois fois supérieure à celle qu'on obtient au coeur de cette couche ; il est préférable que le niveau de dopage au coeur de cette couche soit suffisamment bas pour limiter les risques de diffusion du césium qui risquerait de limiter le rendement lumineux dans la couche électroluminescente 5, mais soit également suffisamment élevé pour obtenir un niveau de conductivité apte à limiter les pertes ohmiques dans la diode ;
- couche de blocage de trous 4 en 4,7-diphényl-1,10-phénanthroline (Bphen), non dopé, d'épaisseur 10 nm ;
- couche électroluminescente 5 d'épaisseur 20 nm, susceptible d'émettre un rayonnement de teinte rouge ; les matériaux pour cette couche proviennent de la Société COVION : produit dénommé en 2004 « TMM-004 » dopé à 20% en poids avec un dopant phosphorescent dénommé en 2004 « TER-004 » ;
- couche de blocage des électrons 6 dénommé « SPIRO TAD » de la Société COVION, d'épaisseur 10 nm,
- couche supérieure 7 en « Spiro TTB » (Société COVION) dopé p à 2% en poids avec le produit dénommé NDP2 de la Société NOVALED, d'épaisseur 100 nm ; le niveau de dopage est ici approximativement constant dans toute l'épaisseur de la couche ;
- couche métallique d'argent, d'épaisseur 15 nm environ, pour servir d'anode 8, couvert d'une couche d'encapsulation et de protection en SiO, de 80 nm d'épaisseur environ.

Les caractéristiques courant-tension et caractéristiques lumineuses de la diode selon l'invention ainsi obtenue ont été reportées à la figure 4, sur la courbe formées de symboles circulaires blancs.

A titre d'exemple comparatif, on a réalisé une diode identique à celle qui vient d'être décrite, à la seule différence prés que la concentration en dopants donneurs dans la couche inférieure dopée 3 a été maintenue constante.

Les caractéristiques courant-tension et caractéristiques lumineuses de la diode comparative ainsi obtenue ont été reportées également à la figure 4, sur la courbe formées de symboles carrés noirs.

On constate que le gradient de dopage dans la couche organique inférieure dopée au contact de la cathode permet de diminuer sensiblement la tension d'alimentation requise pour obtenir un courant prédéterminé, et donc un éclairement prédéterminé, puisque la tension requise pour obtenir un éclairement de 100 cd/m2 passe de 8,2 V dans l'exemple comparatif à seulement 4,3 V dans l'exemple selon l'invention.

## Revendications

1. Diode organique électroluminescente comprenant :
- un substrat (1),
- une électrode inférieure (2) d'un premier genre du côté du substrat et une électrode supérieure (8) d'un second genre à l'opposé du substrat, les genres d'électrodes correspondant à anode et cathode,
- une couche organique électroluminescente émissive (5) qui est intercalée entre l'électrode inférieure (2) et l'électrode supérieure (8),
- et au moins une couche en matériau organique dopé (3) en contact avec l'une desdites électrodes (2), qui est intercalée entre cette électrode (2) et ladite couche électroluminescente (5), ledit matériau organique étant dopé avec un dopant donneur si ladite électrode en contact est une cathode, avec un dopant accepteur si ladite électrode en contact est une anode, et la concentration en dopant étant nulle ou quasi nulle à la limite de cette couche (3) qui est opposée à ladite électrode (2) avec laquelle elle est en contact, **caractérisé en ce que** :
- le niveau de dopage en dopant de l'au moins une couche organique dopée (3) est plus élevé à l'interface entre cette couche organique (3) et l'électrode (2) au contact de laquelle elle est, qu'au coeur de cette couche organique dopée (3), dès lors que la distance à l'interface avec cette électrode (2) est supérieure à 10 nm,
- dans cette couche organique dopée (3), l'épaisseur de la tranche de concentration nulle ou quasi nulle en dopant est strictement inférieure à l'épaisseur de la tranche de concentration non nulle en dopant,
- il existe une barrière de potentiel supérieure à 0,2 eV audit interface, qui forme une jonction Schottky.

2. Diode selon la revendication 1 **caractérisée en ce que** :
- si ladite électrode à cette interface est une cathode, si le matériau de l'électrode à cette interface est un métal qui présente un travail de sortie E_{M1}, si le matériau O1 de ladite couche organique dopée n en donneurs à cette interface présente un niveau de Fermi E₁ et un niveau de LUMO E_{C1}, alors on a |E_{C1} - E_{M1}| > 0.2 eV et E_{M1} > E₁ ;
- si ladite électrode à cette interface est une anode, si le matériau de l'électrode à cette interface est un métal qui présente un travail de sortie E_{M2}, si le matériau 02 de ladite couche organique dopée p en accepteurs à cette interface présente un niveau de Fermi E₂ et un niveau du HOMO E_{V2}, alors on a |E_{V2} - E_{M2}| > 0.2 eV et E_{M2} < E₂,
où les énergies des niveaux et des travaux de sortie sont ici comptés positivement par rapport au niveau d'énergie d'un électron dans le vide.

3. Diode selon la revendication 1 ou 2 **caractérisée en ce que** la conductivité moyenne du matériau de ladite couche organique dopée (3) est au moins trois fois plus élevée dans une tranche de cette couche de 10 nm d'épaisseur, située à l'interface et au contact avec ladite électrode (2), que dans une tranche d'au moins 10 nm d'épaisseur située au coeur de cette couche organique dopée (3) à plus de 20 nm de ladite électrode (2).

4. Diode selon la revendication 1 ou 2 **caractérisée en ce que** la concentration moyenne en dopant dans le matériau de ladite couche organique dopée (3) est au moins trois fois plus élevée dans une tranche de cette couche située à l'interface et au contact avec ladite électrode (2) que dans une tranche située au coeur de cette couche organique dopée (3) à plus de 10 nm de ladite électrode (2).

5. Diode selon l'une quelconque des revendications précédentes **caractérisée en ce que**, si ladite électrode en contact est une cathode, ledit dopant donneur est apte à augmenter la densité de niveaux d'énergie pour les électrons au voisinage du niveau du LUMO dudit matériau dopé et **en ce que**, si ladite électrode en contact est une anode, ledit dopant accepteur est apte à augmenter la densité de niveaux d'énergie pour les trous au voisinage du niveau du HOMO dudit matériau dopé.

6. Diode selon l'une quelconque des revendications précédentes **caractérisée en ce que**, si ladite électrode en contact est une cathode, la différence, en valeur absolue, entre d'une part l'énergie du niveau du HOMO ou le potentiel d'ionisation du dopant donneur et d'autre part l'énergie du niveau du LUMO dudit matériau organique est inférieure à 5 eV, et/ou **en ce que**, si ladite électrode en contact est une anode, la différence, en valeur absolue, entre d'une part l'énergie du niveau du LUMO ou l'affinité électronique du dopant accepteur et d'autre part l'énergie du niveau du HOMO dudit matériau organique est inférieure à 5 eV.

7. Diode selon la revendication 6 **caractérisée en ce que**, si l'électrode en contact avec la couche dopée est une cathode, l'énergie du niveau du HOMO ou le potentiel d'ionisation du dopant donneur est supérieure à l'énergie du niveau du LUMO du matériau organique de la couche dopée, et/ou **en ce que**, si l'électrode en contact avec la couche dopée est une anode, l'énergie du niveau du LUMO ou l'affinité électronique du dopant accepteur est inférieure ou égale à l'énergie du niveau du HOMO du matériau organique de la couche dopée, où les énergies des niveaux sont ici comptées positivement par rapport au niveau d'énergie d'un électron dans le vide.

8. Diode selon l'une quelconque des revendications précédentes **caractérisée en ce qu'**elle comprend une couche organique de blocage (4 ; 6) intercalée entre l'au moins une couche organique dopée (3 ; 7) et ladite couche électroluminescente (5), blocage de trous si la dite couche organique dopée est au contact d'une cathode, blocage d'électrons si la dite couche organique dopée est au contact d'une anode.

9. Panneau d'éclairage ou d'affichage d'images comprenant un réseau de diodes selon l'une quelconque des revendications précédentes **caractérisé en ce que** les diodes de ce réseau sont supportées par le même substrat.

## Claims

1. An organic light-emitting diode comprising:
- a substrate (1),
- a lower electrode (2) of a first kind on the same side as the substrate and an upper electrode (8) of a second kind on the opposite side to the substrate, the electrode kinds corresponding to anode and cathode,
- an organic emissive electroluminescent layer (5) that is inserted between the lower electrode (2) and the upper electrode (8),
- and at least one layer made of doped organic material (3) in contact with one of said electrodes(2), which layer is inserted between this electrode (2) and said electroluminescent layer (5), said organic material being doped with a donor dopant if said electrode in contact with it is a cathode, or with an accepter dopant if said electrode in contact with it is an anode, and the concentration of dopant being zero or practically zero at the boundary of this layer (3) opposite said electrode (2) with which it is in contact,
**characterized in that**:
- the level of doping of the at least one doped organic layer (3) is higher at the interface between this organic layer (3) and the electrode (2) with which this layer is in contact than in the core of this doped organic layer (3), as soon as the distance from the interface with this electrode (2) is greater than 10 nm,
- in this doped organic layer (3), the thickness of the slice with a zero or practically zero concentration of dopant is less than the thickness of the slice with a non-zero dopant concentration,
- a voltage barrier exists at said interface that is higher to 0.2 eV, said barrier forming a Schottky junction.

2. The diode as claimed in claim 1, **characterized in that**:
- if said electrode at this interface is a cathode, if the material of the electrode at this interface is a metal having a work function E_{M1}, and if the material O1 of said organic layer n-doped with donors at this interface has a Fermi level E₁ and a LUMO level E_{C1}, then |E_{C1} - E_{M1}| > 0.2 eV and E_{M1} > E₁;
- if said electrode at this interface is an anode, if the material of the electrode at this interface is a metal having a work function E_{M2}, and if the material 02 of said organic layer p-doped with acceptors at this interface has a Fermi level E₂ and a HOMO level E_{V2}, then |E_{V2} - E_{M2}| > 0.2 eV and E_{M2} < E₂,
wherein level energies and work function are counted positive from the energy level of an electron in vacuum.

3. The diode as claimed in claim 1 or 2, **characterized in that** the average conductivity of the material of said doped organic layer (3) is at least three times higher in a 10 nm thick slice of this layer, located at the interface and in contact with said electrode (2), than in an at least 10 nm thick slice located in the core of this doped organic layer (3) at more than 20 nm from said electrode (2).

4. The diode as claimed in claim 1 or 2, **characterized in that** the average dopant concentration in the material of said doped organic layer (3) is at least three times higher in a slice of this layer, located at the interface and in contact with said electrode (2), than in a slice located in the core of this doped organic layer (3) at more than 10 nm from said electrode (2).

5. The diode as claimed in any one of the preceding claims, **characterized in that**, if said contacting electrode is a cathode, said donor dopant is capable of increasing the density of electron energy levels near the LUMO level of said doped material and **in that**, if said contacting electrode is an anode, said accepter dopant is capable of increasing the density of hole energy levels near the HOMO level of said doped material.

6. The diode as claimed in any one of the preceding claims, **characterized in that**, if said contacting electrode is a cathode, the difference in absolute value between, on the one hand, the HOMO level energy or ionization potential of the donor dopant and, on the other hand, the LUMO level energy of said organic material is less than 5 eV, and/or **in that**, if said contacting electrode is an anode, the difference in absolute value between, on the one hand, the LUMO level energy or electron affinity of the acceptor dopant and, on the other hand, the HOMO level energy of said organic material is less than 5 eV.

7. The diode as claimed in claim 6, **characterized in that**, if the electrode in contact with the doped layer is a cathode, the HOMO level energy or ionization potential of the donor dopant is higher than the LUMO level energy of the organic material of the doped layer and/or **in that**, if the electrode in contact with the doped layer is an anode, the LUMO level energy or electron affinity of the acceptor dopant is equal to or lower than the HOMO level energy of the organic material of the doped layer, wherein level energies are counted positive from the energy level of an electron in vacuum.

8. The diode as claimed in any one of the preceding claims, **characterized in that** it includes an organic blocking layer (4; 6) inserted between at least one doped organic layer (3; 7) and said electroluminescent layer (5), which blocks holes if said doped organic layer is in contact with a cathode and blocks electrons if said doped organic layer is in contact with an anode.

9. An illuminating panel or image display screen comprising an array of diodes as claimed in any one of the preceding claims, **characterized in that** the diodes of this array are supported by the same substrate.

## Patentansprüche

1. Organische Elektrolumineszenzdiode mit
- einem Substrat (1),
- einer unteren Elektrode (2) einer ersten Art substratseitig und einer oberen Elektrode (8) einer zweiten Art entgegengesetzt zu dem Substrat, wobei die Elektrodenarten der Anode bzw. der Kathode entsprechen,
- einer organischen Elektrolumineszenz-Emissionsschicht (5), die zwischen der unteren Elektrode (2) und der oberen Elektrode (8) angeordnet ist, und
- mindestens einer eine der Elektroden (2) kontaktierenden Schicht aus einem dotierten organischen Material (3), welche zwischen dieser Elektrode (2) und der Elektrolumineszenzschicht (5) angeordnet ist, wobei das organische Material mit einem Donator-Dotierstoff dotiert ist, wenn die kontaktierte Elektrode eine Kathode ist, oder mit einem Akzeptor-Dotierstoff dotiert ist, wenn die kontaktierte Elektrode eine Anode ist, und wobei die Dotierstoffkonzentration gleich Null oder annähernd Null ist am Ende dieser Schicht (3), die der von ihr kontaktierten Elektrode (2) entgegengesetzt ist, **dadurch gekennzeichnet, dass**
- das Dotierungsniveau der mindestens einen dotierten organischen Schicht (3) höher ist an der Schnittstelle zwischen dieser organischen Schicht (3) und der von ihr kontaktierten Elektrode (2), als in dem Kern dieser dotierten organischen Schicht (3), wenn der Abstand an der Schnittstelle zu dieser Elektrode (2) größer ist als 10 nm,
- in dieser dotierten organischen Schicht (3) die Dicke des Abschnitts mit einer Dotierstoffkonzentration, die gleich Null oder annähernd Null ist, strikt geringer ist als die Dicke des Abschnitts mit einer Dotierstoffkonzentration, die nicht gleich Null ist,
- es an der Schnittstelle, die einen Schottky-Übergang bildet, einen Potenzialwall gibt, der höher als 0,2 eV ist.

2. Diode nach Anspruch 1, **dadurch gekennzeichnet, dass**,
- wenn die Elektrode an dieser Schnittstelle eine Kathode ist, wenn das Material der Elektrode an dieser Schnittstelle ein Metall mit einer Austrittsarbeit E_{M1} ist, wenn das Material O1 der mit Donatoren dotierten organischen Schicht n an dieser Schnittstelle ein Fermi-Niveau E₁ und ein LUMO-Niveau E_{C1} aufweist, sich dann folgende Beziehungen ergeben: |E_{C1} - E_{M1}| > 0,2 eV und E_{M1} > E₁,
- wenn die Elektrode an dieser Schnittstelle eine Anode ist, wenn das Material der Elektrode an dieser Schnittstelle ein Metall mit einer Austrittsarbeit E_{M2} ist, wenn das Material 02 der mit Akzeptoren dotierten organischen Schicht p an dieser Schnittstelle ein Fermi-Niveau E₂ und ein HOMO-Niveau E_{V2} aufweist, sich dann folgende Beziehungen ergeben: |E_{V2} - E_{M2}| > 0,2 eV und E_{M2} < E₂,
- wobei hier die Energien der Niveaus und der Austrittsarbeiten in Bezug auf das Energieniveau eines Elektrons im Vakuum positiv gezählt werden.

3. Diode nach Anspruch 1 oder 2, **dadurch gekennzeichnet, dass** die mittlere Leitfähigkeit des Materials der dotierten organischen Schicht (3) in einem 10 nm dicken Abschnitt dieser Schicht, der sich an der Schnittstelle befindet und die Elektrode (2) kontaktiert, mindestens drei Mal größer ist als in einem mindestens 10 nm dicken Abschnitt, der sich in dem Kern dieser dotierten organischen Schicht (3) in einem Abstand von mehr als 20 nm zu der Elektrode (2) befindet.

4. Diode nach Anspruch 1 oder 2, **dadurch gekennzeichnet, dass** die mittlere Dotierstoffkonzentration in dem Material der dotierten organischen Schicht (3) in einem Abschnitt dieser Schicht, der sich an der Schnittstelle befindet und die Elektrode (2) kontaktiert, mindestens drei Mal höher ist als in einem Abschnitt, der sich in dem Kern dieser dotierten organischen Schicht (3) in einem Abstand von mehr als 10 nm zu der Elektrode (2) befindet.

5. Diode nach einem beliebigen der vorhergehenden Ansprüche, **dadurch gekennzeichnet, dass**, wenn die kontaktierte Elektrode eine Kathode ist, der Donator-Dotierstoff geeignet ist, die Dichte von Energieniveaus für die Elektronen in der Nähe des LUMO-Niveaus des dotierten Materials zu erhöhen, und dass, wenn die kontaktierte Elektrode eine Anode ist, der Akzeptor-Dotierstoff geeignet ist, die Dichte von Energieniveaus für die Löcher in der Nähe des HOMO-Niveaus des dotierten Materials zu erhöhen.

6. Diode nach einem beliebigen der vorhergehenden Ansprüche, **dadurch gekennzeichnet, dass**, wenn die kontaktiere Elektrode eine Kathode ist, der Betrag des Unterschieds zwischen der Energie des HOMO-Niveaus oder dem Ionisierungspotenzial des Donator-Dotierstoffs einerseits und der Energie des LUMO-Niveaus des organischen Materials andererseits geringer ist als 5 eV und/oder dass, wenn die kontaktierte Elektrode eine Anode ist, der Betrag des Unterschieds zwischen der Energie des LUMO-Niveaus oder der elektronischen Affinität des Akzeptor-Dotierstoffs einerseits und der Energie des HOMO-Niveaus des organischen Materials andererseits geringer ist als 5 eV.

7. Diode nach Anspruch 6, **dadurch gekennzeichnet, dass**, wenn die von der dotierten Schicht kontaktierte Elektrode eine Kathode ist, die Energie des HOMO-Niveaus oder das Ionisierungspotenzial des Donator-Dotierstoffs größer ist als die Energie des LUMO-Niveaus des organischen Material der dotierten Schicht und/oder dass, wenn die von der dotierten Schicht kontaktierte Elektrode eine Anode ist, die Energie des LUMO-Niveaus oder die elektronische Affinität des Akzeptor-Dotierstoffs geringer als oder gleich der Energie des HOMO-Niveaus des organischen Materials der dotierten Schicht ist, wobei hier die Energien der Niveaus in Bezug auf das Energieniveau eines Elektrons im Vakuum positiv gezählt werden.

8. Diode nach einem beliebigen der vorhergehenden Ansprüche, **dadurch gekennzeichnet, dass** sie eine organische Blockierschicht (4; 6) umfasst, die zwischen der mindestens einen dotierten organischen Schicht (3; 7) und der Elektrolumineszenzschicht (5) angeordnet ist - Blockierung von Löchern, wenn die dotierte organische Schicht eine Kathode kontaktiert und Blockierung von Elektronen, wenn die dotierte organische Schicht eine Anode kontaktiert.

9. Beleuchtungs- bzw. Bildanzeigeschirm mit einem Array aus Dioden nach einem beliebigen der vorhergehenden Ansprüche, **dadurch gekennzeichnet, dass** die Dioden dieses Arrays von einem selben Substrat getragen werden.
